# EUROPÄISCHE PATENTSCHRIFT

(11) **EP 1 150 158 B1**
(45) Veröffentlichungstag und Bekanntmachung des Hinweises auf die Patenterteilung: **22.01.2003**
(21) Anmeldenummer: 01102863.6
(22) Anmeldetag: 14.02.2001
(51) Int. Cl.: G03B 9/06, G02B 5/00, G03F 7/20, G02B 26/02

(54) **Irisblende**
Iris diaphragm
Diaphragme iris

(30) Priorität: 05.04.2000 DE 10016925
(43) Veröffentlichungstag der Anmeldung: 31.10.2001
(73) Patentinhaber: Carl Zeiss, 89518 Heidenheim (Brenz) (DE); Carl-Zeiss-Stiftung, trading as Carl Zeiss, 89518 Heidenheim (Brenz) (DE)
(72) Erfinder: Bischoff, Thomas, 73433 Aalen (DE)
(74) Vertreter: Lorenz, Werner, Dr.-Ing.

(56) Entgegenhaltungen:
- US-A- 2 949 076
- US-A- 4 199 247
- US-A- 4 367 931
- US-A- 4 695 145
- US-A- 5 140 212

## Beschreibung

Die Erfindung betrifft eine Irisblende, insbesondere für ein Belichtungsobjektiv in der Halbleiter-Lithographie, nach der im Oberbegriff von Anspruch 1 näher definierten Art.

Bei bisherigen Irisblenden, wie z.B. aus US 4 199 247A bekannt, auch bei Irisblenden für Belichtungsobjektive in der Halbleiter-Lithographie, werden Durchmesseränderungen der Blendenöffnung durch eine oszillierende Bewegung erreicht. Die Durchmesserveränderung wird dabei durch eine Vielzahl von Lamellen durchgeführt, die jeweils mit einem Ende in einem sogenannten Blendenboden und mit ihrem anderen Ende jeweils in einem Nutenring gelagert sind. Die Lamellen sind sichelartig gekrümmt und eine oszillierende Antriebseinrichtung führt die Lamellen je nach Drehrichtung mehr oder minder tief sehnenartig in die Blendenöffnung ein, wodurch das durchtretende Lichtbündel beschnitten wird.

Die oszillierende Bewegung, wobei nicht unerhebliche Massen zu bewegen sind, wirkt sich mit den daraus resultierenden Belastungen nachteilig auf die Lebensdauer der Irisblende aus. Dies gilt insbesondere, wenn hohe Zyklen gegeben sind, wie dies z.B. bei einem Belichtungsobjektiv in der Halbleiter-Lithographie der Fall ist.

Der vorliegenden Erfindung liegt daher die Aufgabe zugrunde, eine Irisblende der eingangs erwähnten Art zu schaffen, die eine hohe Lebensdauer besitzt, insbesondere die auch bei hohen Öffnungs- und Schließzyklen für die Lamellen präzise und verschleißarm arbeitet.

Erfindungsgemäß wird diese Aufgabe durch die im kennzeichnenden Teil von Anspruch 1 genannten Merkmale gelöst.

Anstelle einer oszillierenden Bewegung wird durch die erfindungsgemäße Ausgestaltung des Nutenringes mit den Nutzbereichskurven und den Rückführkurven in der gewählten Ausgestaltung eine lineare bzw. kontinuierliche Drehbewegung mit einer in sich geschlossenen Umlaufbahn erreicht. Eine kontinuierliche Drehbewegung wirkt im Vergleich zu einer oszillierenden Bewegung wesentlich geringer belastend auf die an der Bewegung beteiligten Teile.

In einer erfindungsgemäßen Ausgestaltung kann vorgesehen sein, daß die Rückführbereiche wenigstens annähernd als Mehrfachpolynome ausgebildet sind. Durch ein Mehrfachpolynom kann erreicht werden, daß eine hohe Kräftefreiheit während der Drehbewegung geschaffen wird, womit auch sehr schnelle Schaltbewegungen zur Verstellung der Lamellen möglich sind. Durch das erfindungsgemäße Mehrfachpolynom wird auch ein stetiger Übergang und damit ein stetiger Kraftverlauf ohne Sprünge erreicht.

In einer weiteren Ausgestaltung der Erfindung kann vorgesehen sein, daß die Lamellen jeweils mit einem Lager versehen sind, über die sie jeweils in der Umlaufbahn geführt sind, wobei bei Verwendung der Lager als Wälzlager, was bei der Lösung nach dem Stand der Technik nicht ohne weiteres möglich war, eine hohe Reibungsarmut erreicht wird.

In einer sehr vorteilhaften Ausgestaltung kann dabei vorgesehen sein, daß jede Lamelle jeweils zwei Wälzlager nach Art einer Parallelführung besitzt.

Da in der Regel die Lamellenbleche relativ dünn sind und deshalb bei Dauerbelastungen entsprechend gefährdet sind, läßt sich durch die erfindungsgemäße Lagerung eine höhere Sicherheit und damit eine längere Standzeit erreichen.

Eine sehr vorteilhafte Weiterbildung der Erfindung kann darin bestehen, daß die Antriebsdrehrichtung der Antriebseinrichtung und die Verläufe der Nutzbereichskurven und der Rückführkurven so gewählt sind, daß sich beim Öffnen der Blendenöffnung in den Bahnbereichen der Rückführkurven eine Zugkraft auf die Lamellen einstellt.

Diese erfindungsgemäße Kraftrichtung ist entgegengesetzt zu der Bewegungsrichtung beim Stand der Technik, wobei auf die Lamellen eine Zugkraft ausgeübt wird, wenn sich die Blende schließt. Auf diese Weise erhält man nämlich bei den oszillierenden Bewegungen sogenannte gleichläufige Kurven, womit die Kräfte auf die Lamellen und die Nieten, über die die Lamellen mit dem Nutenring und den Blenden verbunden sind, leichter zu beherrschen sind.

Zwar ist mit der erfindungsgemäßen Lösung in den Nutzkurvenbereichen nunmehr ein etwas schlechterer Kraftverlauf gegeben, aber aufgrund der Möglichkeit der besseren Lagerung der Lamellen, z.B. mit Wälzlager, und der kontinuierlichen Drehbewegung ist dies ohne Schwierigkeiten möglich. Andererseits wird durch diesen Bewegungsverlauf in den Rückführkurven ein besserer Kraftverlauf erreicht.

Aus Montagegründen kann es von Vorteil sein, wenn die Nutzbereichskurven oder die Rückführkurven als durchgehende Schlitze in dem Nutenring ausgeführt sind.

Nachfolgend ist anhand der Zeichnung ein Ausführungsbeispiel der Erfindung prinzipmäßig beschrieben.

Es zeigt:
- Figur 1: eine halbseitige Darstellung (teilweise im Schnitt) der erfindungsgemäßen Irisblende mit einer Antriebseinrichtung in perspektivischer Darstellung;
- Figur 2: eine perspektivische Darstellung eines Nutenringes; und
- Figur 3: eine Ansicht der Irisblende im Halbschnitt und in einer perspektivischen Darstellung von schräg unten her gesehen.

Grundsätzlich ist die Irisblende von bekannter Bauart, weshalb nachfolgend nur auf die für die Erfindung wesentlichen Teile näher eingegangen wird.

Die Irisblende weist einen Nutenring 1 auf und einen darunter angeordneten Blendenboden 2. Jeweils über Wälzlager 3 sind Lamellen 4 mit einem Ende in dem Nutenring geführt und mit dem anderen Ende über Wälzlager 5 in dem Blendenboden 2 gelagert.

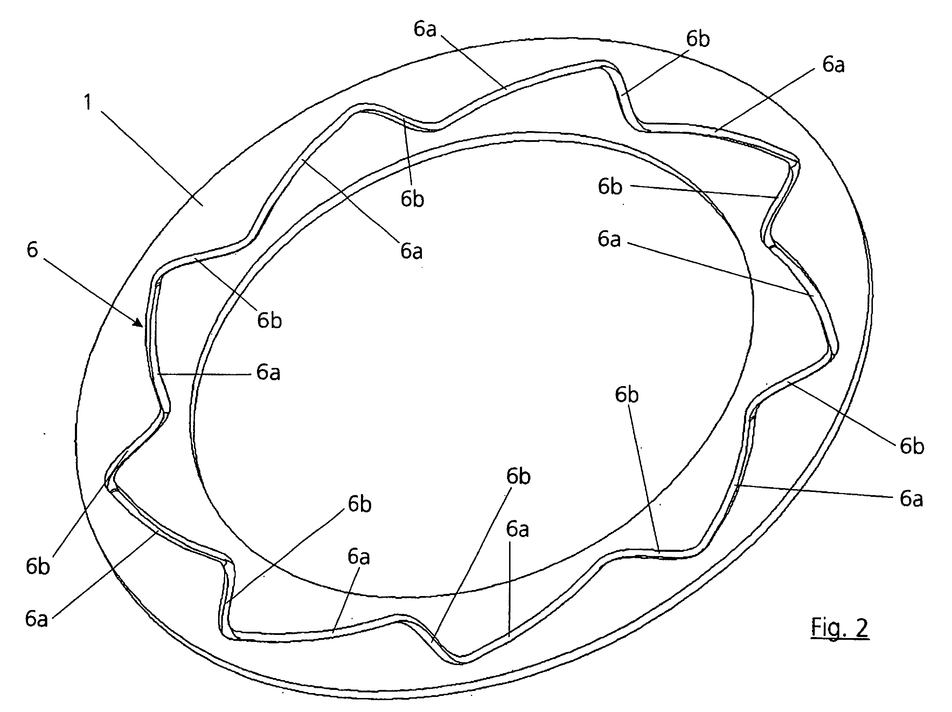

Der Nutenring 1 ist mit einer Umlaufbahn 6 versehen, die die Kurvenbahnen für die Verstellung der Lamellen 4 bildet und die in sich abwechselnde Nutzbereichskurven 6a und Rückführkurven 6b derart aufgeteilt ist, daß sich eine geschlossene Umlaufbahn ergibt (siehe Fig. 2). In der Umlaufbahn 6 laufen die Wälzlager 3, womit die Lamellen 4 entsprechend umlaufend geführt sind. Die Rückführbereiche 6b sind jeweils wenigstens annähernd als Mehrfachpolynome ausgebildet.

Aus Stabilitätsgründen und zur besseren Führung sind für jede Lamelle 4 jeweils zwei Wälzlagerpaare 3 bzw. 5 nach Art einer Par allelführung vorgesehen.

Ein großes Wälzlager 7 dient dazu, den Nutenring 1 bei seiner Drehung gegenüber dem Blendenboden 2 zu führen. Das Wälzlager 7 ist mit einem Lagerflansch 8 verbunden, der mit dem Blendenboden 2 verbunden ist und daher mit dem Blendenboden 2 verdreht wird.

Die andere Seite des Wälzlagers 7 ist an einem Gehäuse 9 der Irisblende befestigt. An einer Flanschplatte 10 des Gehäuses 9 ist ein Antriebsmotor als Antriebsdreheinrichtung 11 befestigt. Der Antriebsmotor 11 ist mit einem Antriebsritzel 12 versehen, welches in Zahneingriff mit einem Zahnrad 13 steht. Das Zahnrad 13 ist mit dem Lagerflansch 8 verbunden und treibt damit diesen zusammen mit dem Blendenboden 2 an. Dies bedeutet, der Blendenboden 2 dreht sich, während der Nutenring 1, in welchem die Lamellen 4 mit ihren Wälzlagern 3 in der Umlaufbahn 6 geführt sind, feststeht. Selbstverständlich ist jedoch auch die umgekehrte Lösung denkbar, wobei sich der Nutenring 1 dreht und der Blendenboden 2 feststeht.

Die Antriebsdrehrichtung des Antriebsmotors 11 ist dabei so gewählt, daß sich beim Öffnen der Blendenöffnung, d.h. bei einer Bewegung der Lamellen 4 nach außen, eine Zugkraft auf die Lamellen 4 in den Rückführkurven 6b ergibt.

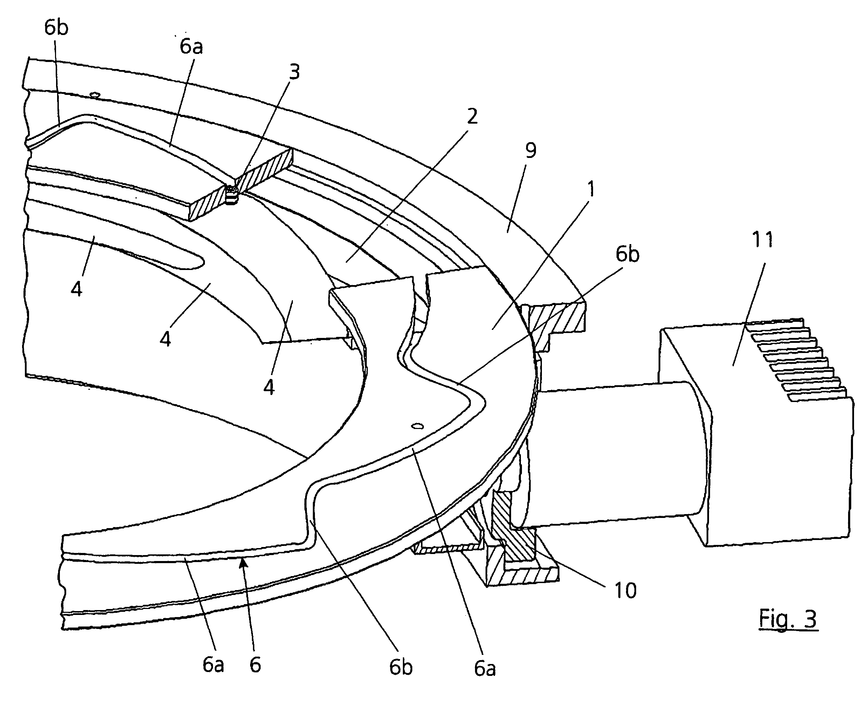

Aus Montagegründen ist die Umlaufbahn 6 zum Teil als durchgehender Schlitz ausgebildet. Dies ist jeweils im Bereich der Nutzbereichskurven 6a der Fall, während die Rückführkurven 6b lediglich als Einfräsungen in die Oberseite des Nutenringes 1 ausgebildet sind. In der Fig. 3 sind deshalb die Rückführkurven 6b nur gestrichelt angedeutet, da die Fig. 3 die Ansicht von schräg unten darstellt.

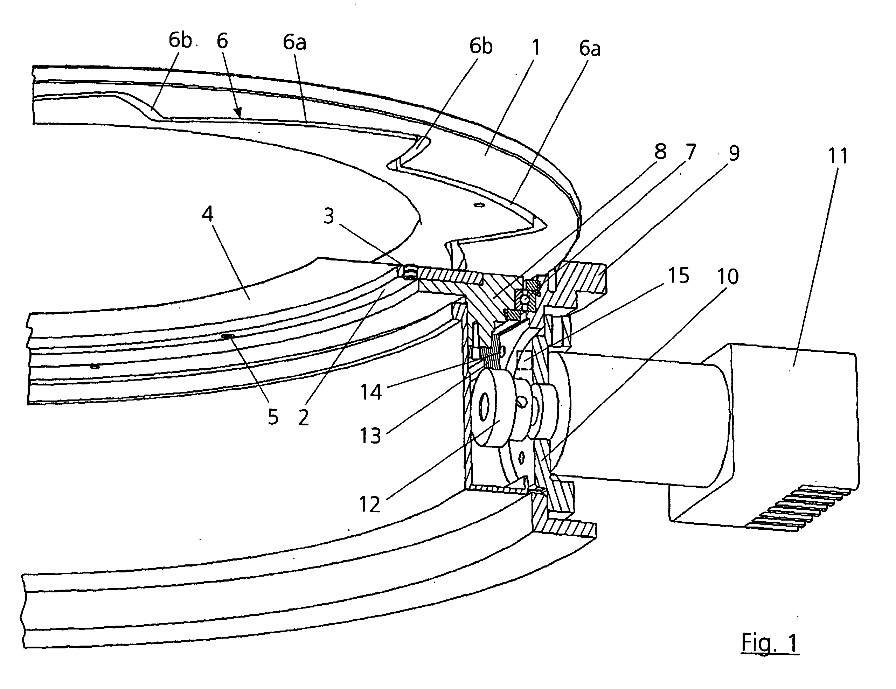

Da nunmehr anstelle einer oszillierenden Bewegung des Blendenbodens 2 eine umlaufende Bewegung stattfindet, sollte ein Wegmeßsystem verbunden sein, um stets eine exakte Positionierung und eine entsprechende Kontrolle zu erhalten. Hierzu kann z.B. eine nicht näher dargestellte Schaltnocke 14 an dem Zahnrad 13 angeordnet sein, die durch einen Sensor, z.B. einen berührungslosen Sensor 15 (gestrichelte Darstellung in der Fig. 1), abgetastet wird. Derartige Wegmeßsysteme und hierzu erforderliche Einrichtungen sind allgemein bekannt, weshalb nachfolgend hierauf nicht näher eingegangen wird.

## Patentansprüche

1. Irisblende, insbesondere für ein Belichtungsobjektiv in der Halbleiter-Lithographie, mit einem Blendenboden (2), und mit einem Nutenring (1), welche relativ zueinander drehbar sind, mit einer Vielzahl von Lamellen (4), die jeweils in dem Blendenboden (2), und in dem Nutenring (1) gelagert und durch im Nutenring (1) angeordnete Kurvenbahnen (6) zur Verstellung der Blendenöffnung geführt sind, und mit einer Antriebseinrichtung (11, 12, 13) zur Verdrehung von Blendenboden (2) und Nutenring (1) zueinander, **dadurch gekennzeichnet, daß** die Kurvenbahnen als Umlaufbahn (6) in dem Nutenring (1) ausgebildet sind, welche in sich abwechselnde Nutzbereichskurven (6a) und Rückführkurven (6b) aufgeteilt ist, und daß der Blendenboden (2) oder der Nutenring (1) durch die Antriebseinrichtung (11) in eine vorgewählte Antriebsdrehrichtung drehbar ist, wobei die Lamellen (4) umlaufend in der Umlaufbahn (6) geführt sind.

2. Irisblende nach Anspruch 1, **dadurch gekennzeichnet, daß** die Rückführbereiche (6b) wenigstens annähernd als Mehrfachpolynome ausgebildet sind.

3. Irisblende nach Anspruch 1 oder 2, **dadurch gekennzeichnet, daß** die Lamellen (4) jeweils mit Lagern (3, 5) versehen sind, über die sie jeweils in der Umlaufbahn (6) geführt und in dem Blendenboden (2) gelagert sind.

4. Irisblende nach Anspruch 3, **dadurch gekennzeichnet, daß** die Lager als Wälzlager (3, 5) ausgebildet sind.

5. Irisblende nach Anspruch 4, **dadurch gekennzeichnet, daß** für jede Lamelle (4) jeweils zwei Wälzlager (3, 5) nach Art einer Parallelführung vorgesehen sind.

6. Irisblende nach einem der Ansprüche 1 bis 5, **dadurch gekennzeichnet, daß** die Antriebsdrehrichtung der Antriebseinrichtung (11) und die Verläufe der Nutzbereichskurven (6a) und der Rückführkurven (6b) so gewählt sind, daß sich beim Öffnen der Blendenöffnung in den Bahnbereichen der Rückführkurven (6b) eine Zugkraft auf die Lamellen (4) einstellt.

7. Irisblende nach einem der Ansprüche 1 bis 6, **dadurch gekennzeichnet, daß** die Nutzbereichskurven (6a) oder die Rückführkurven (6b) als durchgehende Schlitze in dem Nutenring (1) ausgeführt sind.

## Claims

1. An iris diaphragm, in particular for an exposure lens in semiconductor lithography, comprising a diaphragm base (2) and a grooved ring (1) which are rotatable relatively to one another, a multiplicity of leaves (4) each of which is pivoted in the diaphragm base (2) and in the grooved ring (1) and is guided by cam tracks arranged in the grooved ring (1) for adjusting the diaphragm aperture, and a drive arrangement (11, 12, 13) for rotating the diaphragm base (2) and the grooved ring (1) relatively to one another, **characterised in that** the cam tracks are configured as an orbital track (6) in the grooved ring (1), which orbital track (6) is divided into alternating useful range cams (6a) and return cams (6b), and **in that** the diaphragm base (2) or the grooved ring (1) is rotatable by means of the drive arrangement (11) in a preselected drive direction, the leaves (4) being guided orbitally in the orbital track (6).

2. An iris diaphragm according to Claim 1, **characterised in that** the return sections (6b) are configured at least approximately as multiple polynomials.

3. An iris diaphragm according to Claim 1 or 2, **characterised in that** the leaves (4) are in each case provided with bearings (3, 5) by means of which they are guided respectively in the orbital track (6) and in the diaphragm base (2).

4. An iris diaphragm according to Claim 3, **characterised in that** the bearings are configured as roller bearings (3, 5).

5. An iris diaphragm according to Claim 4, **characterised in that** for each leaf (4) two roller bearings (3,5) are provided in the manner of a parallel guide.

6. An iris diaphragm according to one of claims 1 to 5, **characterised in that** the direction of rotation of the drive arrangement (11) and the paths of the useful range cams (6a) and of the return cams (6b) are so selected that on opening of the diaphragm aperture a tensile force is exerted on the leaves (4) in the track sections of the return cams (6b).

7. An iris diaphragm according to one of claims 1 to 6, **characterised in that** the useful range cams (6a) or the return cams (6b) are executed as through-slots in the grooved ring (1).

## Revendications

1. Diaphragme iris, en particulier pour un objectif d'éclairage dans la lithographie des semi-conducteurs, comprenant un fond de diaphragme (2) et une bague à rainures (1) qui peuvent tourner l'un par rapport à l'autre, une pluralité de lamelles (4) tourillonnées dans le fond de diaphragme (2) et dans la bague à rainures (1) et qui sont guidées par des chemins incurvés (6) formés dans la bague à rainures (1) pour le changement de réglage de l'ouverture du diaphragme, et un dispositif d'entraînement (11, 12, 13) servant à faire tourner le fond de diaphragme (2) et la bague à rainures (1) l'un rapport à l'autre, **caractérisé en ce que** les chemins incurvés sont réalisés sous la forme d'une piste périphérique (6) formée dans la bague à rainures (1) et qui est divisée en courbes de régions utiles (6a) et en courbes de rappel (6b) qui alternent entre elles, et **en ce que** le fond de diaphragme (2) ou la bague à rainures (1) peuvent être mis en rotation dans un sens de rotation choisi à l'avance par le dispositif d'entraînement (11), les lamelles (4) étant guidées le long de la périphérie dans la piste périphérique (6).

2. Diaphragme iris selon la revendication 1, **caractérisé en ce que** les zones de rappel (6b) sont réalisées au moins approximativement sous la forme de polynômes répétitifs.

3. Diaphragme iris selon la revendication 1 ou 2, **caractérisé en ce que** les lamelles (4) sont pourvues chacune de paliers (3, 5) au moyen desquels elles sont guidées dans la piste périphérique (6) et tourillonnées dans le fond de diaphragme (2).

4. Diaphragme iris selon la revendication 3, **caractérisé en ce que** les paliers sont constitués par des roulements (3, 5).

5. Diaphragme iris selon la revendication 4, **caractérisé en ce que**, pour chaque lamelle (4), il est prévu à chaque fois deux roulements (3, 5) à la façon d'un guidage parallèle.

6. Diaphragme iris selon l'une des revendications 1 à 5, **caractérisé en ce que** le sens de rotation du dispositif d'entraînement (11) et le tracé des courbes des régions utiles (6a) et des courbes de rappel (6b) sont choisis de manière que, lors de l'ouverture du diaphragme, il s'exerce une force de traction sur les lamelles (4) dans les zones de trajectoire des cames de rappel (6b).

7. Diaphragme iris selon l'une des revendications 1 à 6, **caractérisé en ce que** les courbes de régions utiles (6a) ou les courbes de rappel (6b) sont réalisées sous la forme de fentes ininterrompues dans la bague à rainures (1).
